# EUROPÄISCHE PATENTSCHRIFT

(11) **EP 2 246 740 B1**
(45) Veröffentlichungstag und Bekanntmachung des Hinweises auf die Patenterteilung: **28.12.2011**
(21) Anmeldenummer: 10004378.5
(22) Anmeldetag: 24.04.2010
(51) Int. Cl.: G03F 7/075, G03F 7/32

(54) **Verfahren zur Strukturierung einer Schicht aus Silikon**
Method for structuring a silicone layer
Procédé de structuration d'une couche de silicone

(30) Priorität: 02.05.2009 DE 102009019745
(43) Veröffentlichungstag der Anmeldung: 03.11.2010
(73) Patentinhaber: Karlsruher Institut für Technologie, 76131 Karlsruhe (DE)
(72) Erfinder: Gottwald, Eric, 76149 Karlsruhe (DE); Giselbrecht, Stefan, 76187 Karlsruhe (DE); Scharnweber, Tim, 76694 Forst (DE); Schneider, Andrea, 75015 Bretten (DE); Reinhardt, Martina, 76131 Karlsruhe (DE)
(74) Vertreter: Gärtner, Stephan

(56) Entgegenhaltungen:
- EP-A2- 0 042 562
- PREETHA JOTHIMUTHU ET AL: "Photodefinable PDMS thin films for microfabrication applications" JOURNAL OF MICROMECHANICS & MICROENGINEERING, INSTITUTE OF PHYSICS PUBLISHING, BRISTOL, GB LNKD- DOI:10.1088/0960-1317/19/4/045024, Bd. 19, Nr. 4, 1. April 2009 (2009-04-01), Seite 45024, XP020153391 ISSN: 0960-1317
- EFIMENKO K ET AL: "SURFACE MODIFICATION OF SYLGARD-184 POLY(DIMETHYL SILOXANE) NETWORKS BY ULTRAVIOLET AND ULTRAVIOLET/OZONE TREATMENT" JOURNAL OF COLLOID AND INTERFACE SCIENCE, ACADEMIC PRESS, NEW YORK, NY, US LNKD- DOI:10.1006/JCIS.2002.8594, Bd. 254, 1. Januar 2002 (2002-01-01), Seiten 306-315, XP008064395 ISSN: 0021-9797

## Beschreibung

Die Erfindung betrifft ein Verfahren zur Strukturierung einer Schicht aus Silikon, insbesondere zur Einbringung von mikro- und/oder nanoskaligen Strukturen in eine Schicht aus Silikon.

Mikro- und nanoskalige Strukturen in Silikon, das auch als Polysiloxan oder Polyorganosiloxan bezeichnet wird, finden eine breite Anwendung im Bereich der Lebenswissenschaften. Das Material wird vor allem wegen seiner leicht einstellbaren mechanischen, chemischen und optischen Eigenschaften sowie seiner ausgezeichneten Biokompatibilität geschätzt. Im Bereich des Mikrokontaktdruckens werden die elastischen Eigenschaften der Silikone eingesetzt, um unterschiedlichste Substanzen auf planare Substrate, wie z.B. Glasplättchen oder Siliziumwafern, aufzubringen, wodurch ein großflächiges und fehlerfreies Drucken von Mikro- und Nanostrukturen, ermöglicht wird.

In M. K. J. Ng, I. Gitlin, A. D. Stroock und G. M. Whitesides, Components for integrated poly(dimethylsiloxane) microfluidic Systems, Electrophoresis 23, S. 3461-3473, 2002, wird die elastische Eigenschaft bei der Erzeugung selbstdichtender mikrofluidischer Strukturen genutzt.

Nach J. C. McDonald und G. M. Whitesides, Poly(dimethylsiloxane) as a material for fabricating microfluidic devices, Acc. Chem. Res. 35, S. 491-99, 2002, wird in der Mikrofluidik die chemische Inertheit des Materials gegenüber vielen gängigen organischen Lösungsmitteln sowie verdünnten Säuren und Laugen ausgenutzt.

Trotz dieser guten Beständigkeit gibt es gemäß M. K. J. Ng et al., s. o., und A. Y. Hui, G. Wang, B. Lin und W. T. Chan, Microwave plasma treatment of polymer surface for irreversible sealing of microfluidic devices, Lab Chip 5, S. 1173-77, 2005, dennoch eine Reihe mikrotechnischer Verbindungsverfahren, die z. B. eine irreversible Deckelung von Kanalstrukturen einfach und zuverlässig ermöglichen.

Aus G. M. Whitesides, The origins and the future of microfluidics, Nature 442, S. 368-373, 2006, ist bekannt, dass die hohe Transparenz vieler Silikone die Integration optisch arbeitender Sensor und Detektionsystemen in den Aufbau von Mikrosystemen erlaubt.

Die Strukturierung von Silikon lässt sich mit verschiedenen Verfahren erzielen. Da sich das viskose und noch unvernetzte Silikon sehr einfach und gut gießen lässt, wird in den meisten Fällen wie in A. Kumar, H. A. Biebuyck und G. M. Whitesides, Patterning Self-Assembled Monolayers: Applications in Materials Science, Langmuir 10, S. 1498-1511, 1994, eine Masterstruktur z.B. aus Silizium hergestellt und anschließend durch Abgießen mit Silikon repliziert. Aufgrund der elastischen Eigenschaften lassen sich auch sehr komplexe Geometrien nach der Aushärtung des Silikons noch entformen. Die Herstellung des Masters kann mit bekannten Strukturierungsverfahren, z.B. mikromechanisch oder lithografisch, erfolgen. Einige dieser Verfahren sind jedoch aufwändig und erfordern eine besondere instrumentelle Ausstattung, die nicht in jedem Labor verfügbar ist, was den Zugang zu solchen Strukturen entweder begrenzt oder den Aufwand zur Herstellung erhöht.

Silikonschichten werden dazu eingesetzt, um hoch aufgelöste Strukturen mit Hilfe lithographischer Prozesse in anderen Materialien abzubilden. Allgemein besteht jedoch die Ansicht, dass Silikone gegenüber UV-Licht beständig sind bzw. allenfalls die Oberfläche des Materials verändert wird, siehe K. Efimenko, W.E. Wallace, J. Genzer, Surface modification of Sylgard-184 poly(dimethyl siloxane) networks by ultraviolet and ultraviolet/ozone treatment, J. Colloid Interface Sci. 254, 306-315, 2002.

Alternativ werden wie in K. Tsougeni, A. Tserepi, und F. Gogolides, Photosensitive poly(dimethylsiloxane) materials for microfluidic applications, Microelectronic Engineering 84, S. 1104-08, 2007, spezielle, UV-empfindliche Silikone (*UV curable silicones*) wie ein Fotolack eingesetzt. Eine lokale Belichtung mit UV-Licht und nachfolgender Entwicklung führt zu einer teilweisen Freilegung des darunter liegenden Substrats. Polydimethylsiloxan (PDMS) in Filmen dünner als 1 µm kann mit *vacuum UV* (VUV), das definitionsgemäß den Bereich von 200-10 nm umfasst, sowie mit Elektronenstrahlen und UV-Licht bei 193 nm vernetzt werden. PDMS-Vinyl-Copolymer lässt sich mit *deep UV* (DUV), d.h. bei Wellenlängen unterhalb von 300 nm vernetzen, während für die Fotopolymerisation von PDMS Fotoinitiatoren, sog. *Radikalstarter* beigemischt werden, die bei Wellenlängen zwischen 300-400 nm aktiviert werden. Die belichteten Proben werden üblicherweise nochmals thermisch gehärtet. Im Anschluss hieran werden die zugänglichen Bereiche des Substrats trocken- oder nasschemisch behandelt, z.B. geätzt, wodurch die Struktur in das Substrat übertragen wird. Nicht vernetztes Silikon wurde mit einer 1:1 Mischung von Methylisobutylketon (MIBK) und 2-Propanol herausgelöst. Das Gemisch aus MIBK und 2-Propanol ist im Bereich der optischen Lithographie als Standard-Entwickler bekannt und wird auch gerne für Resists auf der Basis von PMMA eingesetzt.

Ein weiterer Ansatz findet sich in der EP 0 410 760 B1, die lichtempfindliche Zusammensetzungen insbesondere für die Anwendung als positives Resistmaterial offenbart. Die lichtempfindlichen Zusammensetzungen umfassen ein Gemisch aus einem lichtempfindlichen Farbstoff, basierend auf Chinonazid-Verbindungen, und speziellen, alkalilöslichen Polysiloxanen, die mittels Synthese über thermische Cycloaddition erzeugt wurden. Nachteilig hieran ist, dass die Zusammensetzung stets eine lichtempfindliche Substanz enthalten muss, um eine Strukturierung des Polysiloxans zu ermöglichen. Weiterhin muss das eingesetzte Polysiloxan durch die Belichtung alkalilöslich werden, was das Vorhandensein bestimmter funktioneller Strukturen bedingt. Zur Vermeidung einer ungewollten Belichtung ist zudem eine Kontrolle des Raumlichts im Arbeitsbereich erforderlich.

Die strukturierten Silikonschichten dienen gemäß A. Tserepi et al., Etching behavior of Si-containing polymers as resist materials for bilayer lithography: The case of poly-dimethyl siloxane, J. Vacuum Science & Technology B: Microelectronics and Nanometer Structures 21, S. 174-182, 2003, somit als Schutzlack für nachfolgende Ätz- und Entwicklungsprozesse.

Eine einfache Vervielfältigung der Struktur ist durch ein Abgießen des Silikonmasters prinzipiell möglich. Dabei muss jedoch der ursprünglich strukturierte Silikonmaster die inverse Struktur besitzen.

Vor allem im biomedizinischen Bereich lassen sich bisher die sehr häufig benutzten etablierten Silikontypen nicht einsetzen, so dass man hierfür auf spezielle UV-empfindliche Silikontypen angewiesen ist.

Preetha Jothimuthu et al., Photodefinable PDMS thin film for microfabrication applications, J. Micromech. Microeng. 19, S. 45024, 2009, beschreiben die Herstellung von Mikrostrukturen in PDMS durch UV-Belichtung eines mit Benzophenon versetzten, nicht ausgehärteten Präpolymers, sogenanntes photoPDMS. Das Verfahren beginnt mit dem Aufschleudern einer dünnen Schicht photoPDMS auf ein Substrat, die anschließend durch eine Maske bestrahlt wird. Dabei reagiert das Benzophenon mit den für die Polymerisation des Silikons (Hydrosilylierung) erforderlichen funktionelle Gruppen. Deshalb können nach einer thermischen Aushärtung des Silikons die bestrahlten, nicht polymerisierten Bereiche mit Lösungsmittel (z.B. Toluol) weggewaschen werden. Die kleinsten mit Hilfe dieser Technik zu erreichenden Strukturen liegen im Bereich von etwa 100 µm.

Aufgabe der Erfindung ist es daher, ein weiteres Verfahren zur Strukturierung einer Schicht aus Silikon bereitzustellen, das die genannten Nachteile und Einschränkungen nicht besitzt.

Insbesondere soll ein Verfahren zur direkten Strukturierung von bereits vernetztem Silikon zur einfachen und schnellen Herstellung von Strukturen, insbesondere von mikrofluidischen Strukturen, bereitgestellt werden. Dieses Verfahren soll es ermöglichen, die sehr häufig benutzten etablierten Silikontypen einsetzen zu können, um nicht auf spezielle UV-empfindliche Silikontypen angewiesen zu sein. Weiterhin soll sich dieses Verfahren auch für dicke Schichten eignen.

Gelöst wird diese Aufgabe durch die Schritte des Verfahrens gemäß Patentanspruch 1. Die übrigen Ansprüche beschreiben vorteilhafte Ausgestaltungen der Erfindung.

Das erfindungsgemäße Verfahren zur Strukturierung einer Schicht aus Silikon umfasst die Schritte a) bis c).

Im ersten Schritt a) wird eine Schicht aus Silikon (Polysiloxan, Polyorganosiloxan) das vorzugsweise keine spezielle photoaktivierbare Gruppe enthält, bevorzugt in Form von planaren Platten, Folien oder als dünne Schichten auf einem Substrat aufgebracht, bereitgestellt; zuvor aus einem Gemisch aus Silikon und Härter hergestellt und daher in fester Phase vorliegend.

In einer bevorzugten Ausgestaltung enthält die bereitgestellte Schicht aus vernetztem Silikon vernetzte Polysiloxane, die unsubstituiert sind oder mit einer Alkylgruppe, einer substituierten Alkylgruppe, einer Arylgruppe und/oder einer substituierten Arylgruppe als organische Substituenten versehen sind.

In einer besonders bevorzugten Ausgestaltung enthält die bereitgestellte Schicht aus vernetztem Silikon Dialkylpolysiloxane, insbesondere mit Alkylgruppen, die linear, verzweigt oder zyklisch aufgebaut sind und vorzugsweise 1 bis 10 Kohlenstoffatome aufweisen, insbesondere eine Methyl-, Ethyl-, Propyl-, Butyl-, Hexyl-, Octyl-, Decyl-, Isopropyl-, Isobutyl-, tert-Butyl-, 2-Ethylhexyl- oder Cyclohexylgruppe; vorzugsweise Polydimethylsiloxan (PDMS).

Die bereitgestellte Schicht aus Silikon kann bereits mit einer bestehenden Struktur versehen sein.

Im nächsten Schritt b) wird die Schicht aus vernetztem Silikon zumindest teilweise einer Belichtung mit ultraviolettem Licht (UV-Licht) der Wellenlänge im Bereich von 10 nm bis 400 nm, bevorzugt von 100 nm bis 300 nm, besonders bevorzugt von 150 nm bis 300 nm, vorzugsweise mit einer Dosis von 0,001 J/cm² bis 1000 J/cm² unterzogen. Für die gewählte Art der Bestrahlung ist eine einfache Niederdruckquecksilber-Dampflampe ausreichend, die UV-Licht im Wellenlängenbereich von 185 nm emittiert, wobei die partielle Bestrahlung der Silikonoberfläche mit Schattenmasken erfolgt. Für sehr kleine Strukturen eignen sich die aus der klassischen Lithographie bekannten strukturierten Chrom-Quarzglasmasken, oder die sehr kleinen Strukturen werden mittels UV-Lasern in die Schicht geschrieben.

Bei einer Bestrahlung der Schicht aus vernetztem Silikon mit UV-Licht im genannten Wellenlängenbereich kommt es zu Kettenbrüchen im vernetzten Molekül. Bei Anwesenheit von Luftsauerstoff entstehen niedermolekulare Bestandteile mit Si-OH-Gruppen. Die bestrahlten Bereiche zeigen je nach Dosis eine starke Versprödung, wodurch sich Spannungsrisse ausbilden können.

Im letzten Schritt c) werden die belichteten Bereiche mittels eines Entwicklers, der aus einer Mischung aus einem aliphatischen Alkohol mit einer Kettenlänge von 1 bis 3, und einer Lauge im Verhältnis von 2:1 bis 1:2, vorzugsweise von 1:1 ± 20 %, besteht und darüber hinaus ggf. weitere Substanzen enthält, bei einem basischen pH gequollen und sehr selektiv herausgelöst. Hierfür wird eine Mischung aus Methanol, Ethanol und/oder Propanol mit 0,5-molarer bis 2-molarer, insbesondere 1-molare, NaOH oder KOH im Verhältnis von 2:1 bis 1:2, vorzugsweise von 1:1 ± 20 %, der ggf. weitere Substanzen zugemischt sind, eingesetzt.

Im Gegensatz zum Stand der Technik werden erfindungsgemäß dem Silikon keine lichtempfindlichen Komponenten zugesetzt. Allein die Bestrahlung der Polysiloxane mit hochenergetischem UV-Licht in Gegenwart von Sauerstoff erzeugt alkalilösliche Bereiche. Der diesem Vorgang zu Grunde liegende Mechanismus ist radikalisch und daher nicht auf die Anwesenheit spezieller funktioneller Gruppen oder Strukturen angewiesen. Das Fehlen chromophorer Gruppen erlaubt den Einsatz von Polysiloxanen, die bis in den nahen UV-Bereich eine hohe Transparenz aufweisen, was sie insbesondere für optische Anwendungen gut geeignet macht.

Entgegen der allgemeinen Ansicht, dass Silikone gegenüber UV-Licht beständig sind bzw. dass sich damit allenfalls die Oberfläche des Materials verändern lässt, wurden mit dem erfindungsgemäßen Verfahren Strukturen mit einer Tiefe von bis zu 10 µm erreicht.

Mit dem erfindungsgemäßen Verfahren lassen sich kostengünstig und schnell nano- und/oder mikroskalige Strukturen in etablierten und vielfach benutzten Silikonen erzeugen. Hieran ist besonders vorteilhaft, dass sich hiermit sowohl dünne Schichten, freitragende Membranen als auch dicke Platten aus Silikon nachträglich nach dem Vernetzungsprozess strukturieren lassen. Auf diese Weise hergestellte Silikonstrukturen eignen sich für das Mikrokontaktdrucken oder für mikrofluidische Anwendungen.

Die vorliegende Erfindung wird im Folgenden anhand von Ausführungsbeispielen näher erläutert.

Das Gießen einer Silikon-Probe zur Bereitstellung einer Schicht aus Silikon gemäß Schritt a) erfolgte durch Ansetzen eines 2-Komponenten-Silikon-Elastomers nach den Vorgaben des Herstellers im gewünschten Verhältnis der Komponenten nach Gewicht und Aushärten der Probe im Ofen oder bei Raumtemperatur.

Hieran anschließend wurde gemäß Schritt b) die Silikon-Probe unter Auflegen der gewünschten Maske auf die Probe aus Silikon-Elastomer bei der gewählten Wellenlänge (hier: 185 nm-Linie aus dem Spektrum einer Niederdruck-Quecksilberdampflampe) für die jeweils gewünschte Dauer bestrahlt.

Schließlich wurde das Silikon gemäß Schritt c) herausentwickelt, indem die bestrahlte Silikonprobe vollständig mit Entwicklerlösung bedeckt und für etwa 1 Stunde unter Schütteln entwickelt wurde. Danach wurde die Probe gut mit demineralisiertem Wasser (VE-Wasser) gespült.

Die **Tabelle** enthält eine Übersicht über die getesteten Entwicklungsparameter und die Beurteilung hinsichtlich der Güte der hierdurch jeweils erzeugten Strukturen im angegebenen Silikon. Hierbei bezeichnen die Angaben von +++ bis --- für die Stufenhöhe und die Rauhigkeit eine sehr gute bis eine ungenügende Qualität.

**Tabelle: Übersicht über getestete Entwicklungsparameter und Beurteilung hinsichtlich der Güte der Strukturerzeugung**

| **Material / Hersteller** | **Entwicklerlösung** | **Entwicklungsdauer [h]** | **Bestrahlungsenergie DUV [J/cm²]** | **Stufenhöhe** | **Rauhigkeit** |
|---|---|---|---|---|---|
| Elastosil RT 625 / Wacker | Ethanol/ NaOH | 1 | 1,4 | + + + | + |
| Sylgard 186 / Dow Corning | Ethanol/ NaOH | 1 | 1,4 | + | + |
| Sylgard 184 / Dow Corning | Ethanol/ NaOH | 1 | 8,4 | + + + | - |
| | Ethanol/ NaOH | 1 | 1,4 | + + | - |
| | Ethanol/ 0,5M NaOH | 1 | 1,4 | - | + |
| | Ethanol/ 0, 5M NaOH | 2 | 1,4 | + | + |
| | Ethanol/ 0,75M NaOH | 1 | 1,4 | + | + |
| | Ethanol/ 1,25M NaOH | 1 | 1,4 | + | + |
| | Ethanol/ 1,4M NaOH | 1 | 1,4 | - | - - |
| | 2-Propanol/ NaOH | 1 | 1,4 | + + | - |
| | Na₂CO₃ / Ethanol / NaOH | 1 | 1,4 | + | + |
| | Ca (OH) 2 / Ethanol | 1 | 1,4 | - - - | - |
| | TRIS / Ethanol | 1 | 1,4 | - - - | + |
| | EDTA/ Ethanol | 1 | 1,4 | - - - | + |
| | Jod / Ethanol | 1 | 1,4 | - - - | - |
| | Ethanolamin | 1 | 1,4 | - - | - - |
| | NH₃/H₂O₂ | 1 | 1,4 | - | - |
| | K₃PO₄ / Ethanol / NaOH | 1 | 1, 4 | - | + |
| | NH₃-Lösung | 1 | 1,4 | - - | + + |

## Patentansprüche

1. Verfahren zur Strukturierung einer Schicht aus Silikon mit den **Schritten**
a) Bereitstellen einer Schicht aus vernetzem Silikon, das aus einem Gemisch aus Silikon und Härter hergestellt wird,
b) Teilweises Belichten der Schicht aus vernetztem Silikon mit ultraviolettem Licht einer Wellenlänge im Bereich von 10 nm bis 400 nm,
c) Selektives Herauslösen der belichteten Bereiche aus der Schicht aus vernetztem Silikon mittels eines Entwicklers, der eine Mischung aus Methanol, Ethanol und/oder Propanol mit 0,5-molarer bis 2-molarer NaOH oder KOH im Verhältnis von 2:1 bis 1:2 enthält.

2. Verfahren nach Anspruch 1, wobei eine Schicht aus vernetztem Silikon, enthaltend vernetzte Polysiloxane, die mit einer Alkylgruppe, einer substituierten Alkylgruppe, einer Arylgruppe und/oder einer substituierten Arylgruppe versehen sind, bereitgestellt wird.

3. Verfahren nach Anspruch 2, wobei eine Schicht aus vernetztem Silikon, enthaltend Dialkylpolysiloxane, bereitgestellt wird.

4. Verfahren nach Anspruch 3, wobei eine Schicht aus vernetztem Silikon, enthaltend Dialkylpolysiloxane mit Alkylgruppen, die linear, verzweigt oder zyklisch aufgebaut sind und 1 bis 10 Kohlenstoffatome aufweisen, bereitgestellt wird.

5. Verfahren nach Anspruch 4, wobei eine Schicht aus vernetztem Silikon, enthaltend Polydimethylsiloxan, bereitgestellt wird.

6. Verfahren nach einem der Ansprüche 1 bis 5, wobei eine Schicht aus vernetztem Silikon, das keine spezielle photoaktivierbare Gruppe enthält, bereitgestellt wird.

7. Verfahren nach einem der Ansprüche 1 bis 6, wobei die Belichtung der Schicht aus Silikon mit ultraviolettem Licht einer Dosis von 0,001 J/cm² bis 1000 J/cm² erfolgt.

8. Verfahren nach einem der Ansprüche 1 bis 7, wobei die Belichtung der Schicht aus Silikon mit ultraviolettem Licht einer Wellenlänge im Bereich von 100 nm bis 300 nm erfolgt.

9. Verfahren nach Anspruch 8, wobei die Belichtung der Schicht aus Silikon mit ultraviolettem Licht einer Wellenlänge im Bereich von 150 nm bis 300 nm erfolgt.

10. Verfahren nach einem der Ansprüche 1 bis 9, wobei das selektive Herauslösen der belichteten Bereiche aus der Schicht aus vernetztem Silikon mittels eines Entwicklers, der eine Mischung aus Methanol, Ethanol und/oder Propanol mit 0,5-molarer bis 2-molarer NaOH oder KOH im Verhältnis von 1:1 ± 20 % enthält, erfolgt.

## Claims

1. Method for structuring a layer of silicone, comprising the following **steps**
a) providing a layer of cross-linked silicone that is made of a mixture of silicone and hardener,
b) partially exposing the layer of cross-linked silicone to ultraviolet light having a wavelength of 10-400 nm,
c) selectively removing of the exposed areas from the layer of cross-linked silicone by a developer that contains a mixture of methanol, ethanol and/or propanol with 0.5 molar to 2 molar NaOH or KOH in a ratio of 2:1 to 1:2.

2. Method according to claim 1, wherein a layer of cross-linked silicone is provided that contains cross-linked polysiloxanes having an alkyl group, a substituted alkyl group, an aryl group and/or a substituted aryl group.

3. Method according to claim 2, wherein a layer of cross-linked silicone is provided that contains dialkylpolysiloxanes.

4. Method according to claim 3, wherein a layer of cross-linked silicone is provided that contains dialkylpolysiloxanes with alkyl groups that are formed in linear, branch or cyclic manner and have 1-10 carbon atoms.

5. Method according to claim 4, wherein a layer of cross-linked silicone is provided that contains polydimethylsiloxane.

6. Method according to one of the claims 1 bis 5, wherein a layer of cross-linked silicone is provided that contains no special photoactive group.

7. Method according to one of the claims 1 to 6, wherein the layer of silicone is exposed with ultraviolet light at a dose of 0.001-1,000 J/cm².

8. Method according to one of the claims 1 to 7, wherein the layer of silicone is exposed with ultraviolet light having a wavelength of 100-300 nm.

9. Method according to claim 8, wherein the layer of silicone is exposed with ultraviolet light having a wavelength of 150-300 nm.

10. Method according to one of the claims 1 to 9, wherein the selective removal of the exposed areas from the layer of cross-linked silicone is performed by a developer that contains a mixture of methanol, ethanol and/or propanol with 0.5 molar to 2 molar NaOH or KOH in a ratio 1:1 ± 20%.

## Revendications

1. Procédé de structuration d'une couche de silicone comportant les étapes constituant à :
a) Préparer une couche de silicone réticulé obtenue à partir d'un mélange de silicone et d'un durcisseur ;
b) Irradiation partielle de la couche de silicone réticulé avec de la lumière ultraviolette dont la longueur d'onde est située dans la plage de 10 nm à 400 nm ;
c) Elimination sélective des zones irradiées de la couche de silicone réticulé à l'aide d'un élément révélateur renfermant un mélange de méthanol, éthanol et/ou propanol avec NaOH ou KOH 0,5 à 2 molaire dans un rapport de 2 : 1 à 1 : 2.

2. Procédé conforme à la revendication 1,
selon lequel
on prépare une couche de silicone réticulé renfermant des polysiloxanes réticulés comprenant un groupe alkyl, un groupe alkyl substitué, un groupe aryl et/ ou un groupe aryl substitué.

3. Procédé conforme à la revendication 2,
selon lequel
on prépare une couche de silicone réticulé renfermant des dialkylpolysiloxanes.

4. Procédé conforme à la revendication 3,
selon lequel
on prépare une couche de silicone réticulé renfermant des dialkylpolysiloxanes comportant des groupes alkyl linéaires ramifiés ou cycliques et 1 à 10 atomes de carbone.

5. Procédé conforme à la revendication 4,
selon lequel
on prépare une couche de silicone réticulé renfermant du polydiméthyl-siloxane.

6. Procédé conforme à l'une des revendications 1 à 5,
selon lequel
on prépare une couche de silicone réticulé qui ne renferme pas de groupe photo activable particulier.

7. Procédé conforme à l'une des revendications 1 à 6,
selon lequel
l'irradiation de la couche de silicone s'effectue avec de la lumière ultraviolette à une dose de 0,001 J/cm² à 1000 J/cm².

8. Procédé conforme à l'une des revendications 1 à 7,
selon lequel
l'irradiation de la couche de silicone s'effectue avec de la lumière ultraviolette ayant une longueur d'onde située dans la plage de 100 nm à 300 nm.

9. Procédé conforme à la revendication 8,
selon lequel
l'irradiation de la couche de silicone s'effectue avec de la lumière ultraviolette ayant une longueur d'onde située dans la plage de 150 nm à 300 nm.

10. Procédé conforme à l'une des revendications 1 à 9,
selon lequel
l'élimination sélective des zones irradiées de la couche de silicone réticulé s'effectue au moyen d'un élément révélateur qui renferme un mélange de méthanol, éthanol et/ou propanol avec NaOH ou KOH 0,5 à 2 molaire dans un rapport de 1 : 1 ± 20 %.
